# EUROPEAN PATENT APPLICATION

(11) **EP 2 186 930 A1**
(43) Date of publication of application: **19.05.2010**
(21) Application number: 08790676.4
(22) Date of filing: 27.06.2008
(51) Int. Cl.: C30B 29/22

(54) **ZNO SUBSTRATE AND METHOD FOR PROCESSING ZNO SUBSTRATE**

(30) Priority: 28.06.2007 JP 2007171132; 27.12.2007 JP 2007337435
(71) Applicant: Rohm Co., Ltd., Kyoto-shi, Kyoto 615-8585 (JP)
(72) Inventor: NAKAHARA, Ken, Kyoto-shi Kyoto 615-8585 (JP); YUJI, Hiroyuki, Kyoto-shi Kyoto 615-8585 (JP); AKASAKA, Shunsuke, Kyoto-shi Kyoto 615-8585 (JP); KAWASAKI, Masashi, Sendai-shi Miyagi 980-8577 (JP); OHTOMO, Akira, Sendai-shi Miyagi 980-8577 (JP); TSUKAZAKI, Atsushi, Sendai-shi Miyagi 980-8577 (JP)
(74) Representative: TBK-Patent
(86) International application number: PCT/JP2008/061711
(87) International publication number: WO 2009/001919

(57) **Abstract**

Provided are a ZnO-based substrate having a surface suitable for crystal growth, and a method of manufacturing the ZnO-based substrate. The ZnO-based substrate is made in a way that almost no hydroxide groups exist on a crystal growth-side surface of a MgₓZn₁₋ₓO substrate (0≤x<1). To this end, as a method of treating the substrate, a final treatment to be applied on the crystal growth-side surface of the MgₓZn₁₋ₓO substrate (0≤x<1) is acidic wet etching at pH 3 or lower. Thereby, it is possible to prevent production of a hydroxide of Zn, and to reduce the density of crystal defects in a thin film formed on the ZnO-based substrate.

## Description

### Technical Field

The present invention relates to a ZnO-based substrate suitable for crystal growth of a ZnO-based thin film and the like, and to a method of treating the ZnO-based substrate.

### Background Art

Electronics engineering is a field where semiconductor materials, particularly siliconmaterials, play an active role. In recent years, however, it is becoming more difficult to achieve device configurations to satisfy required functions due to property limitations of silicon materials themselves. Such limitations include operational incapability at high temperature equal to or above 150°C and lack of breakdown voltage capability in a high electric field, for example.

In the meantime, oxides and organic materials represented by high-temperature superconductor YBCO, an ultraviolet-emitting material ZnO, an organic EL and the like are drawing attention as next generation materials owing to a variety of species and functional versatility. These substances have a possibility of realizing functions that have not been achieved due to restriction imposed by silicon as the material. For example, ZnO is drawing attention because of its versatility, high light emitting potential, and so forth.

To manufacture a device using ZnO, a sapphire substrate has heretofore been used as a crystal growth substrate for growing a crystalline thin film of ZnO. However, a sapphire substrate has a large degree of lattice mismatch with ZnO as the thin film material, which accounts for as high as about 18%. For this reason, a conventional thin film is likely to have numerous lattice defects, an increase in mosaicness, and the like, and therefore it has been difficult to form a high-quality single-crystal thin film. High light emitting potential and other features of ZnO are exerted only in the form of a high-quality single-crystal thin film. Therefore, a device, which is formed of a ZnO thin film deposited on a sapphire substrate, is incapable of fully exerting intrinsic performances of ZnO. Hence, the sapphire substrate is not always the most suitable substrate for growth.

With this taken into consideration, a proposal has been made on the use of ScAlMgO₄ (SCAM) crystals or the like as a crystal growth substrate because of their smaller lattice mismatch with ZnO. However, a ScAlMgO₄ substrate is a special substrate which is not suitable for industrial applications without modifications. The most desirable solution in the industrial perspective is to use ZnO substrates.
Non-patent Document 1: Ulrike Diebold, et al., Applied Surface Science 237(2004) p. 336-342.
Non-patent Document 2: Chevtchenko, S. A. et al., Applied Physics Letters 89(2006) p. 182111-182113.

### Disclosure of the Invention

### Problems to be Solved by the Invention

However, concerning the ZnO substrate, a normal polishing operation, such as forming a clean surface by wet etching, alone does not make it possible to obtain a flat and clean surface suitable for epitaxial growth (see Non-patent Documents 1 and 2, for example). CMP (chemical mechanical polishing) which is well known as a planarization process is used in order to obtain a surface suitable for epitaxial growth.

In a method using the CMP, chemical mechanical polishing is executed while supplying an alkaline aqueous polishing slurry, which includes dispersed colloidal silica, for example, to a space between a polishing pad such as a rotary one-side polishing apparatus and a process object such as a ZnO substrate. The colloidal silica used as an abrasive (small SiO₂ granules having diameters less than about 5 nm) agglutinates unless the solvent is alkaline. Therefore, the alkaline aqueous polishing slurry is used as described above. However, when polishing with the colloidal silica, the silica which is an ingredient of the abrasive adheres to the ZnO surface. Moreover, since the ZnO substrate is exposed to the alkaline aqueous solution, zinc hydroxide Zn(OH)₂ is formed on the surface of the ZnO substrate.

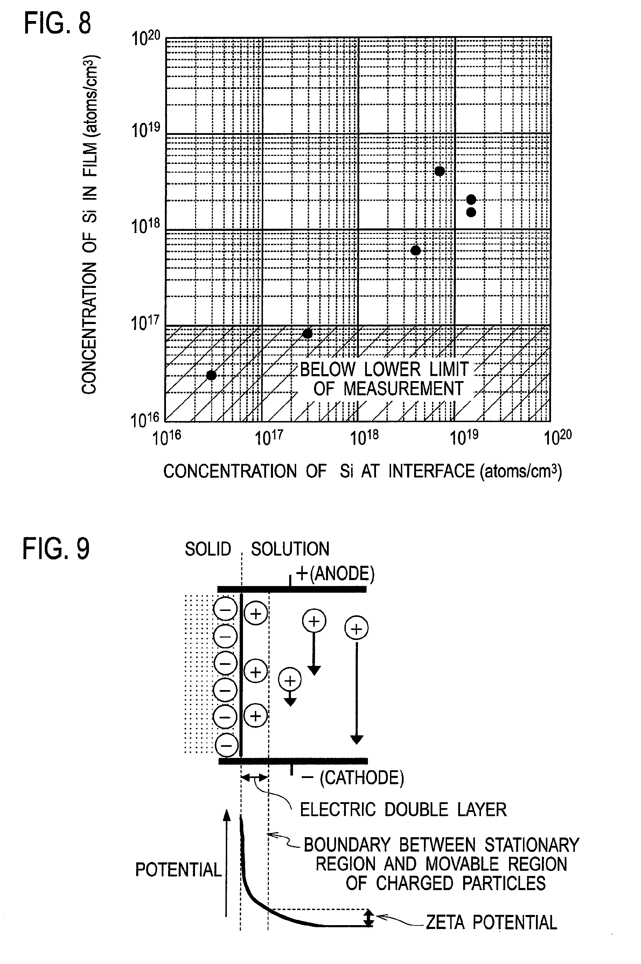

Of those, adhesion of silica appears in the form of Si diffusion afterwards at the time of crystal growth of a ZnO-based thin film. Fig. 8 is a diagram showing how and how much of Si is diffused into the MgZnO thin film if Si exists on an interface between the ZnO substrate and the MgZnO thin film when a MgZnO thin film is formed on a ZnO substrate. The lateral axis is a logarithmic scale indicating an interfacial concentration of Si while the longitudinal axis is a logarithmic scale indicating a concentration of Si in the ZnO thin film.

As shown in Fig. 8, the concentration of Si in the MgZnO thin film increases in accordance with an increase in the interfacial concentration of Si. For this reason, if the concentration of silica adhering to the surface of the ZnO substrate increases, Si diffused into the MgZnO thin film accordingly increases. An increase in the amount of Si serving as a donor causes a problem when forming the thin film into a p-type thin film through doping and when fabricating a device.

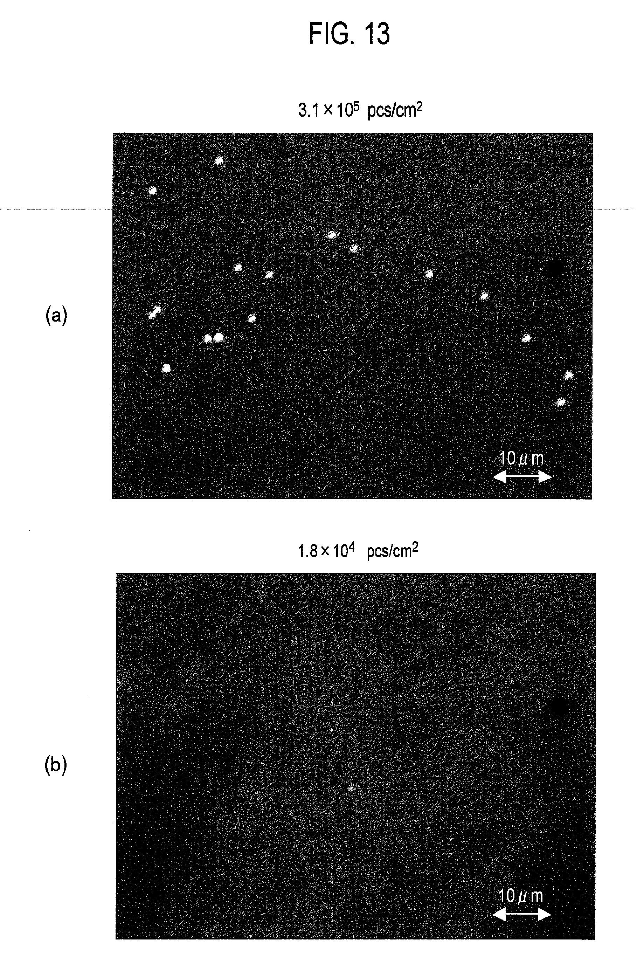

Moreover, the formation of the hydroxide on the surface of the ZnO substrate generates defects on a crystalline film formed on the ZnO substrate, and causes adverse effects in the form of an increase in a pit density. Fig. 13 (a) is a dark-field image of a surface of a MgZnO thin film observed with an optical microscope after the growth of a crystalline thin film of MgZnO on a CMP-treated ZnO substrate. The magnification of the optical microscope is set at 1000 times for observation. As apparent from the image, white round dots represent crystal defects (pits). As a result of counting the number of crystal defects (pits), the pit density turns out to be 3.1×10⁵ pieces /cm².

In addition, Zn(OH)₂, which is the hydroxide of Zn, forms a hydrate which is a gel amorphous substance. Therefore, when particles of the above-described silica or other impurity particles are taken into the gel Zn(OH)_{X}, the particles are apt to remain on the ZnO substrate, and may also cause problems of: diffusion of the silica from the surface of the ZnO substrate to the crystal growth film as described above; and difficulty in cleaning the substrate surface.

The present invention has been made to solve the above-described problems. An object thereof is to provide a ZnO-based substrate having a surface suitable for crystal growth, and to provide a method of processing the ZnO-based substrate.

### Means for Solving the Problems

For the purpose of fulfilling the object, the invention as recited in claim 1 is a zinc-oxide-based substrate in which almost no hydroxide groups exist on a crystal growth-side surface of a Mg_{X}Zn₁₋ₓO substrate (0≤x<1).

The invention as recited in claim 2 is the zinc-oxide-based substrate as recited, in claim in which: the crystal growth-side surface is a main surface of the substrate having a +C plane; and a line normal to the main surface of the substrate is inclined from a c-axis toward an m-axis, the c-axis and m-axis being crystal axes of the substrate.

The invention as recited in claim 3 is the zinc-oxide-based substrate as recited in any one of claims 1 and 2, in which a defect density is equal to or below 1×10⁶ cm⁻² when a surface of a MgyZn_{1-y}O substrate (0≤y<1) crystal-grown on the MgₓZn₁₋ₓO substrate (0≤x<1) is observed by use of optical means.

The invention as recited in claim 4 is a method of processing a zinc-oxide-based substrate, in which a final treatment to be applied on the crystal growth-side surface of the Mg_{X}Zn₁₋ₓO substrate (0≤x<1) is acidic wet etching at pH 3 or lower.

### Effects of the Invention

A ZnO-based substrate of the present invention is formed in a way that almost no OH groups exist on a crystal growth-side surface. Accordingly, it is possible to prevent production of a hydroxide of Zn. Moreover, when a ZnO thin film or a MgZnO thin film is formed on the ZnO-based substrate, it is possible to reduce a crystal defect density of any of these thin films to an extremely low level. Further, as the hydroxide of Zn is not produced, it is also possible to reduce adhesion of particles of silica and the like, and thereby to form a surface suitable for crystal growth.

Meanwhile, by applying an acidic wet etching process pH 3 or lower as a final process on a surface of a ZnO-based substrate, it is possible to eliminate almost all OH groups from the crystal growth-side surface. Hence, an effect similar to the above-described effect is achieved. Moreover, since it is possible to set the zeta potentials of ZnO and particles of silica or the like to the same polarity by the above-described etching, it is possible to further suppress generation of adhesion.

### Brief Description of the Drawings

[Fig. 1] Fig. 1 is a diagram showing a relationship between a pit density of a MgZnO thin film and a substrate temperature during growth which is observed when the MgZnO film is formed on a ZnO substrate.
[ Fig. 2] Fig. 2 is a diagram showing pH dependencies of ZnO, colloidal silica and PSL on zeta potential.
[ Fig. 3] Fig. 3 is a view showing a relationship between pH and potential equilibrium of ZnO.
Fig. 4] Fig. 4 is a diagram showing a difference in the state of core electrons between oxygens in ZnO.
Fig. 5] Fig. 5 is a view showing a difference in the state of core electrons between zincs in ZnO.
[ Fig. 6] Fig. 6 is a diagram showing a relationship among a line normal to a main surface of a substrate, a c-axis, an m-axis and an a-axis which are crystal axes of the substrate.
[Fig. 7] Fig. 7 is a diagram showing a surface of a MgₓZn₁₋ₓO substrate whose main surface has an off angle only in the direction of the m-axis.
[ Fig. 8] Fig. 8 is a diagram showing a state of diffusion of a Si impurity on a MgZnO thin film.
[ Fig. 9] Fig. 9 is a schematic diagram for explaining zeta potential.
[ Fig. 10] Fig. 10 is a diagram showing pH dependencies of zeta potential of Si and PSL.
[ Fig. 11] Fig. 11 is a view showing a relationship between the zeta potential and a concentration of adsorbed PSL.
[Fig. 12] Fig. 12 is a drawing showing observation data on a state of a surface of a CMP-treated ZnO substrate.
[Fig. 13] Fig. 13 is a photographic image showing a comparison in the number of pits between a case of a treated substrate and an untreated substrate.

### Explanation of Reference Numeral

1 MgₓZn_{1-X}O SUBSTRATE

### Best Modes for Carrying Out the Invention

In the present invention, a MgₓZn₁₋ₓO substrate (0≤x<1) is used, and a configuration is worked out for forming a crystal growth-side surface of this substrate into a surface suitable for crystal growth which does not allow adhesion of particles of silica or the like or generation of zinc hydroxide Zn(OH)₂. The following studies are carried out by using a ZnO substrate which represents one of the above-mentioned MgₓZn₁₋ₓO substrates in a case of x=0.

First, a guideline for preventing particle adhesion is zeta potential of a solid in a solution. Fig. 9 shows definition of the zeta potential, which illustrates behaviors of ions in the solution located in and around a boundary between the solid and a liquid. A surface of the solid is generally charged in the solution. When the surface of the solid is charged, charged particles, such as ions in the solutions, having a polarity opposite to that of the surface of the solid are attracted to the surface of the solid. At this time, when a potential is applied vertically as shown in Fig. 9, there appears an interface in which ions start to move depending on the magnitude of the Coulomb' force attributable to charges on the surface of the solid. The potential at a location sufficiently remote from this interface is referred to as the zeta potential.

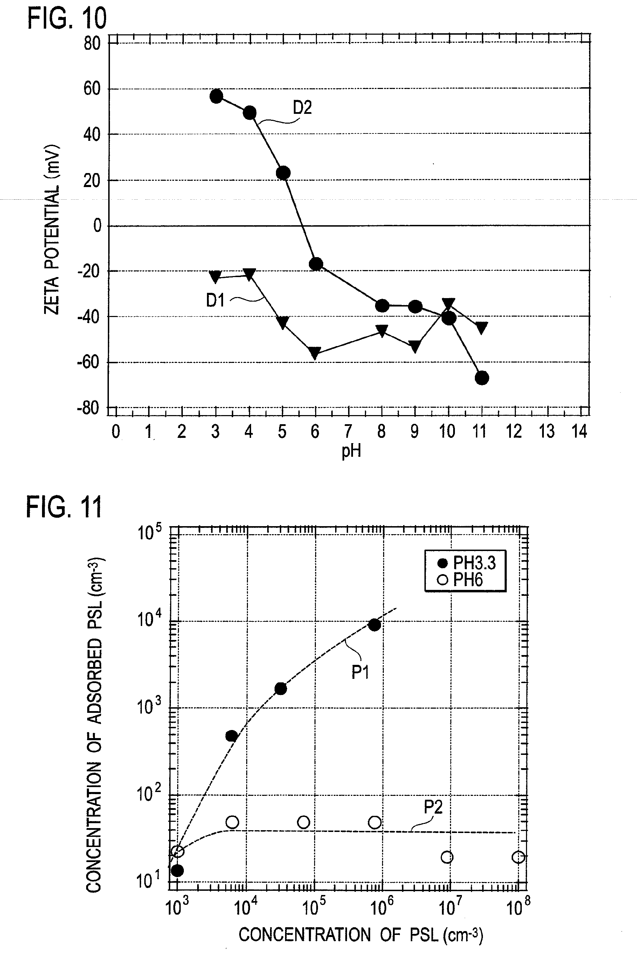

Incidentally, it is known that the zeta potential depends on pH which indicates acidity or alkalinity. Well-known examples will be shown about Si below to explain a relationship between zeta potential and pH, as well as a relationship between zeta potential and particle adhesion. Fig. 10 is a quotation from Tadahiro Ohmi, "Ultraclean ULSI Technology", Baifukan, which shows an example of a pH dependency of the zeta potential. D1 (a curve indicated with ▼) shows a pH dependency of the zeta potential in polystyrene latex (PSL). Meanwhile, D2 (a curve indicated with •) shows a pH dependency of the zeta potential on a surface of a Si substrate. As shown in Fig. 10, the pH dependency of the zeta potential varies if the material type is different.

Next, Fig. 11 shows a relationship between zeta potential and adhesion of particles to the surface of a Si substrate. Like Fig. 10, Fig. 11 is also a quotation from Tadahiro Ohmi, "Ultraclean ULSI Technology", Baifukan. The above-described PSL (polystyrene latex) used as a standard substance for measurement of grain sizes, turbidity, and the like are substituted for the particles, and the Si substrate is immersed in a solution dissolving the PSL. P1 (a curve indicated with •) shows a relationship in concentration (cm⁻³) between PSL in a hydrofluoric acid solution at pH 3.3 and adsorbed PSL adhering to the surface of the Si substrate.

Meanwhile, P2 (a curve indicated with o) shows a relationship in concentration (cm⁻³) between PSL in an ultrapure water solution at pH 6 and adsorbed PSL adhering to the surface of the Si substrate. In the case of P1, since the pH is set to 3.3 as shown in Fig. 10, the zeta potential of the PSL is positive potential at around 50 mV and the zeta potential on the surface of the Si substrate is negative potential at around -20 mV. In this way, the PSL and the surface of the Si substrate have mutually opposite polarities of the zeta potential, and attract each other. For this reason, the concentration of PSL adsorbed to the surface of the Si substrate increases in proportion to an increase in the concentration of PSL.

On the other hand, the pH is set to 6 in the case of P2. Accordingly, as shown in Fig. 10, the zeta potential of the PSL is negative potential at around -20 mV and the zeta potential on the surface of the Si substrate is negative potential at around -60 mV. In this way, the PSL and the surface of the Si substrate have the same polarity of the zeta potential and repel each other. For this reason, the concentration of PSL adsorbed to the surface of the Si substrate hardly change despite the increase in the concentration of PSL, and remains at an extremely low level (below 10² cm⁻³). Accordingly, concerning the particle adhesion, it is apparent that if the zeta potential of the adhering particles and the zeta potential on the surface of the solid have the same polarity, a repulsive force works therebetween, and the particle adhesion hardly occurs.

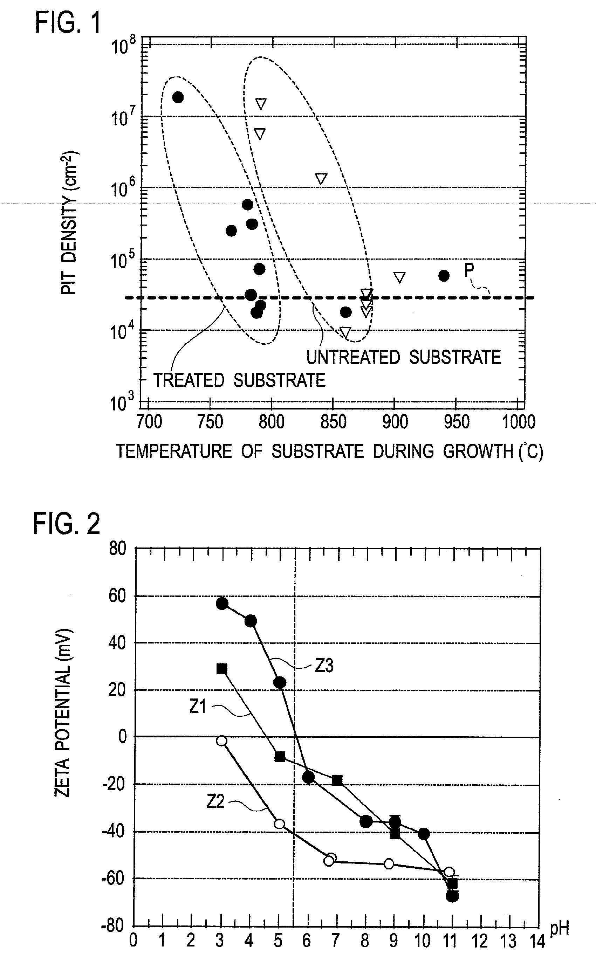

Next, Fig. 2 shows pH dependencies of zeta potential on a +C plane of the ZnO substrate and zeta potential of colloidal silica. Z1 (a curve indicated with black squares) shows a pH dependency of zeta potential on the +C plane of the ZnO substrate; Z2 (a curve indicated with o) shows a pH dependency of zeta potential of colloidal silica; and Z3 shows the above-described pH dependency of the zeta potential in PSL.

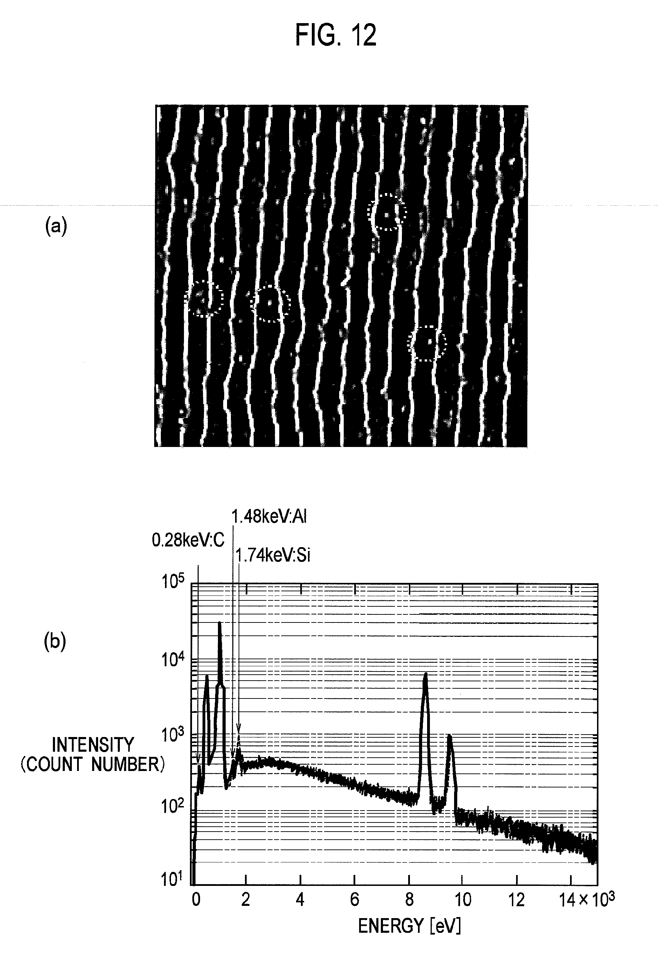

When viewing only this drawing, it seems that, because the zeta potentials of colloidal silica, PSL and ZnO have the same polarity when the pH is on the alkaline side from pH 5.5 (at pH 5.5 or higher) and no particle adhesion occurs. Nevertheless, the case of ZnO is not simple, and adhesion occurs as shown in Fig. 12.

Fig. 12(a) is an image obtained by: subjecting the +C plane of the ZnO substrate to a CMP treatment; then etching this +C plane to etching for 10 minutes using a HF solution at pH of 4.5; and subsequently taking a picture of the C+ plane in a field of 2 µm × 2 µm with an AFM (atomic force microscope). In an area surrounded by a dot line in the drawing, particles seem to be buried. Fig. 12 (b) shows a result of inspection of the surface shown in Fig. 12(a) with an EPMA (electron probe microanalyzer). The lateral axis indicates energy of a characteristic x-ray detected with the EPMA, and the longitudinal axis indicates intensity (a count number). As a peak is observed in a position of the energy equal to 1.74 keV which indicates the substance Si (silicon), it is suspected that colloidal silica (SiO₂) serving as the abrasive adheres to the surface.

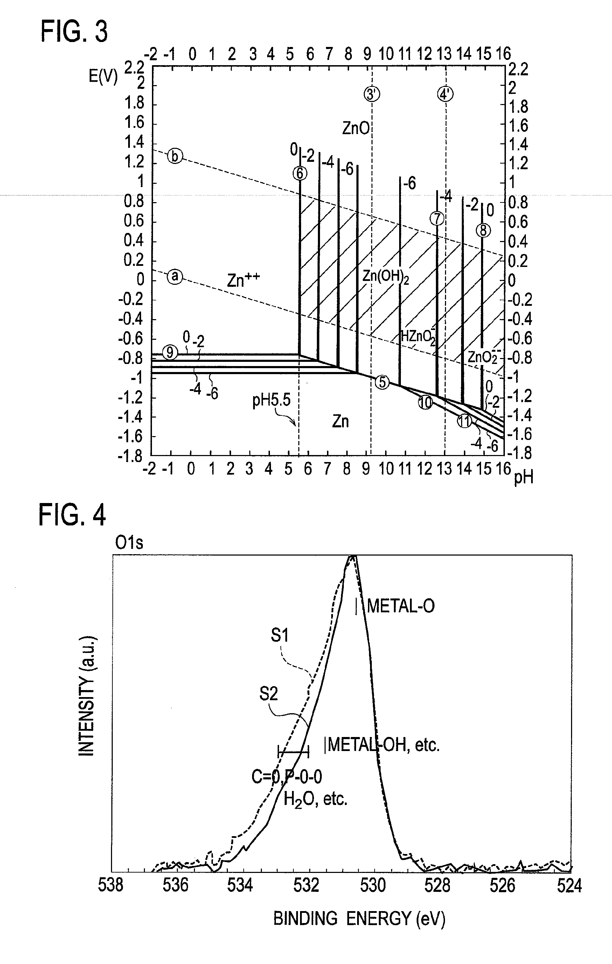

A reason for this will be explained based on Fig. 3. In Fig. 3, the longitudinal axes on the right and left indicate oxidation-reduction potential, and the lateral axes indicate pH. An area interposed by parallel lines a and b shows an equilibrium diagram for water. Meanwhile, a shaded area in the equilibrium diagram for water represents a stable area of Zn(OH)₂. Meanwhile, numbered lines in the diagram show equilibrium states of various types. For example, the number 3 represents Zn²⁺+2H₂O=HZnO²⁻+3H⁺ while the number 4 represents HZnO²⁻=ZnO₂²⁻+H⁺. Both show ionic equilibria. Meanwhile, the number 5 represents an equilibrium between Zn(OH)₂+2H+2e⁻=Zn+2H₂O and a metal/hydroxide; 6 represents an equilibrium between Zn²⁺+2H₂O=Zn(OH)₂+2H⁺ and an aqueous solution/hydroxide; 7 represents an equilibrium between Zn(OH)₂=HZnO²+H⁺ and an aqueous solution/hydroxide; 8 represents an equilibrium between Zn(OH)₂=ZnO₂²+2H⁺ and an aqueous solution/hydroxide; 10 represents an equilibrium between HZnO²⁻+3H⁺+2e⁻=Zn+2H₂O and an aqueous solution / metal; and 11 represents an equilibrium between ZnO2²⁻+4H⁺+2e⁻ and an aqueous solution/metal.

As apparent from Fig. 3, there is the stable area of Zn(OH)₂ on the alkaline side where the pH is equal to or above 5.5. The zinc hydroxide Zn(OH)₂ is a gel material, and the surface of the ZnO substrate is in a sort of sticky state, and plays a role as a sort of adhesive. Therefore, even when the zeta potential on the surface of the ZnO substrate and the zeta potential of colloidal silica are set to the same polarity at pH 5. 5 or higher, there still exists the stable area of Zn(OH) at pH 5.5 or higher. For this reason, Zn(OH)₂ plays a role as as adhesive, and prevents easy repellence and separation.

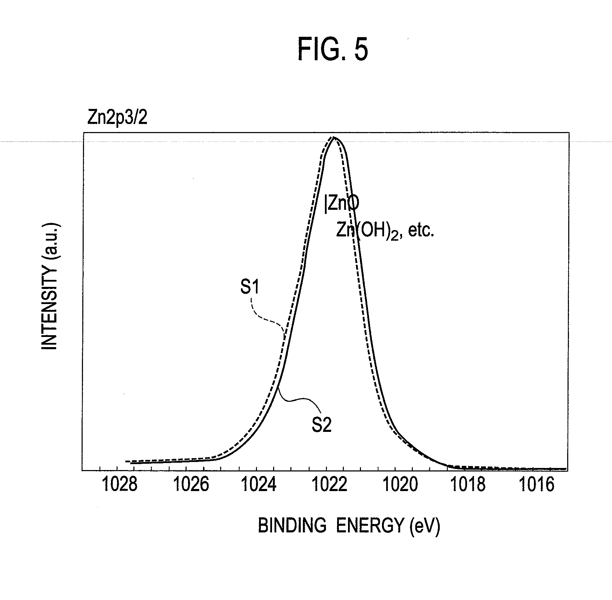

Data in Figs. 4 and 5 are obtained by measuring the surface in this state by XPS (x-ray photoelectron spectroscopy) Fig. 4 shows a difference in the state of core electrons between oxygens (O) on the surface of the ZnO substrate, and represents binding energy of an electron orbit 1s in each oxygen. Meanwhile, Fig. 5 shows a difference in the state of core electrons between zincs (Zn) on the surface of the ZnO substrate, and represents binding energy of an electron orbit 2p3/2 in each zincs. Note that the lateral axes indicate the binding energy and the longitudinal axes indicate the intensity in both of Figs. 4 and 5.

In both of Figs. 4 and 5, a curve S1 shows the difference in the state of core electrons between oxygens or zincs on the untreated substrate. Existence of OH groups can be clearly confirmed by a bulge of a peak on a high energy side which is represented in Fig. 4 in particular. In this state, a pit density increases, which representing crystal defects of a thin film crystal-grown on the ZnO substrate. Fig. 1 is a result of inspection made on a density of crystal defects (a pit density) in a MgZnO thin film which is formed on a ZnO thin film. As shown in the above-described image in Fig. 13, the pit density is calculated by: capturing the dark-field image of the surface of the, MgZnO thin film observed with the optical microscope; and counting the number of white round points, i.e. pits, which is shown in the drawing,. This inspection is performed while changing the growth temperature of the MgZnO thin film, and the counting results are plotted in Fig. 1.

Data, which is obtained when using a ZnO substrate polished by conventional CMP, are indicated with inverted white triangles (V). As shown in the drawing, it is necessary to raise the growth temperature in order to reduce the pit density. Moreover, in a range of the substrate temperature from 750°C to 850°C, the pit densities are concentrated above the order of 1×10⁶ cm⁻².

With this taken into consideration, in order to avoid stable existence of Zn(OH)₂ on the surface of the ZnO substrate and to prevent adhesion of colloidal silica to the surface, it is necessary to at least set the surface of the ZnO substrate at pH less than 5.5 (on the acid side from pH 5.5). When pH is below 5. 5, it may be said that adhesion does not occur easily because there still exists an area where the zeta potential polarities of the ZnO substrate and colloidal silica are the same. However, there is also an area where the zeta potential polarities of the ZnO substrate and colloidal silica are opposite to each other. Moreover, considering avoidance of adhesion of not only colloidal silica but also other particles such as PSL particles, a numerical value, pH less than 3, is derived from Fig. 2 as an area where the respective zeta potentials of the ZnO substrate, colloidal silica and PSL can maintain the same polarity without producing Zn(OH)₂. Therefore, it is desirable to set the surface of the ZnO substrate at pH 3 or in an acidic state higher than pH 3.

In the meantime, the surface of the ZnO substrate is subjected to a wet etching process by using a HC1 (hydrochloric acid) solution at pH 3 or lower (at pH 3 or on the acidic side from pH 3), and then the wet-etched surface of the ZnO substrate is measured by XPS. Curves S2 in Figs. 4 and 5 respectively represent the differences in the state of core electrons between oxygens (O) on the treated surface of the ZnO substrate, as well as the difference in the state of core electrons between zincs (Zn) on the treated surface of the ZnO substrate. Comparing Fig. 4 with Fig. 5, the peak shape changes more significantly in Fig. 4 in particular, thereby indicating that signals originating from the OH groups are weakened. Hence, it is apparent that the OH groups are substantially reduced. In this way, in order to eliminate almost all the OH groups from the surface of the ZnO substrate, it is preferable that a final process for the substrate surface should be achieved by acid wet etching at pH 3 or lower.

Moreover, the MgZnO thin film is formed on the ZnO substrate which is treated by acidic wet etching at pH3 or lower as described above, and an observation is made on the pit density of the MgZnO thin film. A result is shown in Fig. 13 (b) . This is a dark-field image obtained by observing the surface of the MgZnO thin film with the optical microscope under the same capturing condition as that of Fig. 13(a). The observation is made while setting the magnification of the optical microscope at 1000 times. As apparent from comparison with Fig. 13(a), the number of pits is significantly reduced, and the pit density becomes equal to 1.8×10⁴ pieces/cm². Accordingly, by using the high-quality MgZnO thin film with the low pit density, it is possible to fabricate semiconductor devices such as HEMT, and ZnO-based semiconductor light-emitting devices obtained by laminating an n-layer and a p-layer.

In addition, a calculation is made on their pit densities while changing the growth temperature of the MgZnO thin film, and the calculated pit densities are plotted. These are the data already indicated with the black circles (•) in Fig. 1, most of which are included in the area marked as "TREATED SUBSTRATE". When a comparison is made in a range of the growth temperature from 750°C to 850°C, it is apparent that the pit density is considerably lower in the treated substrate than in the untreated substrate. Moreover, when the growth temperature is equal to or above 750°C, all the data (•) on the treated substrate indicate the pit densities are equal to or below 1×10⁶ pieces/cm², and are clearly different from the data on the untreated substrate (indicated with the inverted white triangles: V).

Meanwhile, a line P indicated with a dotted line shows a lower limit value of the pit density that varies depending on the condition on the surface of the ZnO substrate. As apparent from comparison using this line, it is possible for the treated substrate to make the growth temperature of the thin film to be formed on the substrate than the untreated substrate, as long as the pit density of the treated substrate is equal to that of the untreated substrate. Accordingly, it is desirable to achieve the etching process at pH 3 or lower in order to prevent adhesion of particles while preventing production of a hydroxide and setting the zeta potentials of the substrate and particles to the same polarity.

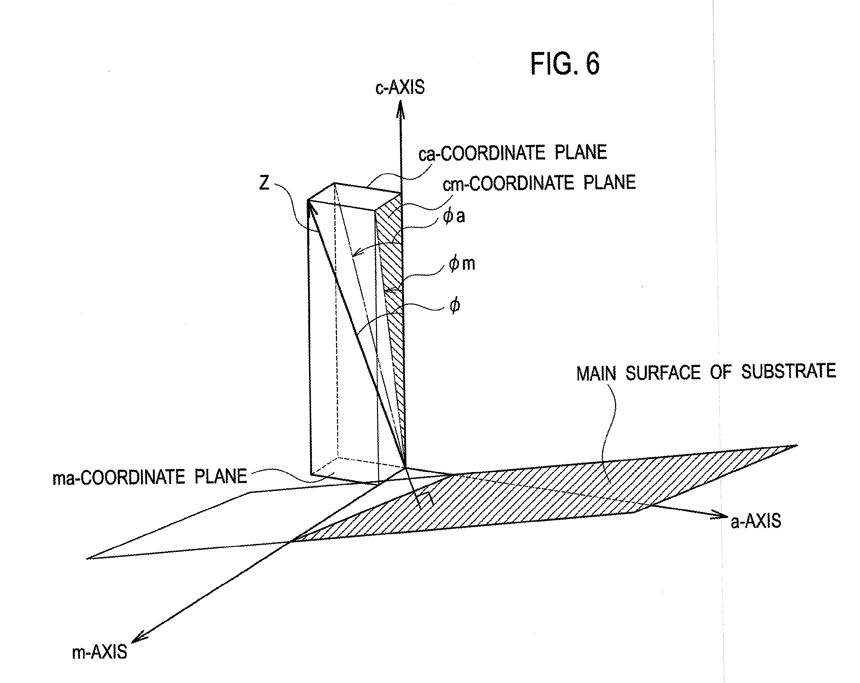

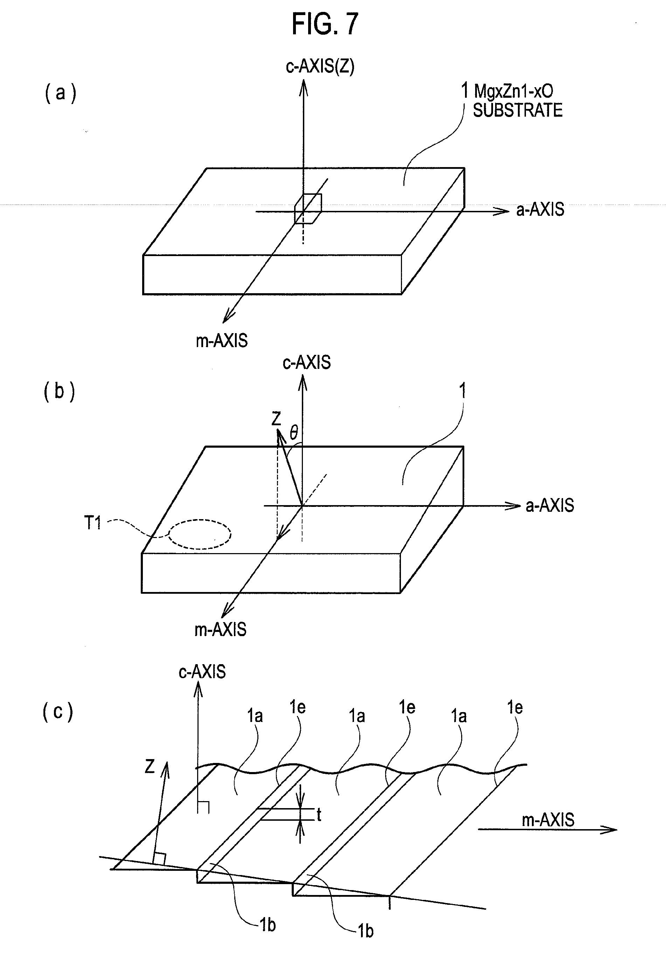

Next, descriptions will be provided for examples of the substrate processes on a crystal growth-side surface of the MgₓZn₁₋ₓO substrate (0≤x<1). In any of the following examples, a main surface of the crystal growth-side surface of the MgₓZn₁₋ₓO substate is formed as shown in Figs. 6 and 7. First, descriptions will be provided for a relationship among a line normal to the main surface of the substrate, a c-axis, an m-axis, and an a-axis, which are crystal axes of the substrate, by using Fig. 6. As shown in Fig. 6, the MgₓZn₁₋ₓO substrate (0≤x<1) is polished in a way that the line normal to the main surface having the +C plane is inclined from the c-axis, and at least toward the m-axis. Fig. 6 shows the main surface of the substrate in which: the normal line Z is inclined from the c-axis of the crystal axis of the substrate at an angle Φ; and a projective axis (a projected axis) defined by projecting (by applying a geometric projection to) the normal line Z to a cm-coordinate plane in an orthogonal coordinate system (c, m, a), where c, m and a denote the c-axis, the m-axis and the a-axis as the crystal axes of the substrate, is inclined toward the m-axis at an angle Φₘ; and a projective axis defined by projecting the normal line Z to a ca-coordinate plane in the orthogonal coordinate system (c, m, a) is inclined toward the a-axis at an angle Φₐ.

Here, descriptions will be provided for the reason for inclining the line normal to the main surface of the substrate at least from the c-axis toward the m-axis. Fig. 7(a) is a schematic diagram showing a main surface of a substrate having the +C plane in which the normal line Z coincides with the c-axis without any inclination toward the a-axis or toward the m-axis. This is the case where the normal line Z in a direction perpendicular to the main surface of the MgₓZn₁₋ₓO substrate 1 coincides with the direction of the c-axis, and where the a-axis, the m-axis, and the c-axis are orthogonal to one another.

However, in the case of a bulk crystal, a direction of the line normal to the main surface of a wafer does not coincide with the direction of the c-axis unlike in the case shown in Fig. 7(a), if not using a cleavage surface intrinsic to the crystal. For this reason, productivity is deteriorated as long as insisting on a substrate with an exact C plane. In reality, the normal line Z to the main surface of the wafer is inclined from the c-axis and has an off angle. As shown in Fig. 7(b), the normal line Z to the main surface is supposed to exist on the cm-coordinate plane and the normal line Z is assumed to be inclined from the c-axis only toward the m-axis by θ degrees. In that case, as shown in Fig. 7(c) which is an enlarged view of a surface portion (such as a T1 area) of the substrate 1, there are formed terrace surfaces 1a which are flat surfaces as well as stepped surfaces 1b having regularity and even intervals at step portions generated by the inclined normal line Z.

Here, the terrace surfaces 1a correspond to the C plane (0001) and the stepped surfaces 1b correspond to an M plane (10-10). As shown in the drawing, the respective stepped surfaces 1b thus formed are arranged regularly in the direction of the m-axis while maintaining widths of the terrace surfaces. That is, the c-axis perpendicular to the terrace surfaces 1a and the normal line Z to the principal surface of the substrate forms the off angle at θ degrees.

As described above, by forming the stepped surface as a surface corresponding to the M plane, it is possible to form the flat film in terms of a ZnO-based semiconductor layer which is crystal-grown on the main surface. Although the step portions are formed on the main surface by the stepped surfaces 1b, atoms coming to the step portions are bound to two surfaces of the terrace surface 1a and the stepped surface 1b so that the coming atoms can be stably trapped.

Although the coming atoms are dispersed inside terraces during a surface diffusion process, stable growth is achieved by lateral growth, in which crystal growth progresses as the atoms are trapped by the step portion having a strong binding force or by a kinked position formed by this step position and are incorporated into the crystal. Incidentally, the stepped surfaces 1b must be chemically stable in order to maintain the condition of the stepped surfaces 1b having the even intervals and regularity as shown in Fig. 7(c), and the M plane is excellent for that purpose.

In particular, it is necessary to use the acidic wet etching equal to or below pH 3 during the substrate processing. Accordingly, in order to ensure stability of the crystal growth surface, it is desirable to configure the main surface on the crystal growth side of the MgₓZn₁₋ₓO substrate so as to have the +C plane and to configure the c-axis of the main surface so as to have the off-angle in the direction of the m-axis. Moreover, the ZnO substrate is used as the MgₓZn₁₋ₓO substrate that applies x=0. It is possible to use HC1 (hydrochloric acid), HF (hydrofluoric acid), HNO₃ (nitric acid) and the like as an acidic solution for the above-described wet etching. However, HC1 is particularly preferable.

### (Example 1)

First, the main surface of the ZnO substrate is subjected to polishing by using colloidal silica to obtain a surface having a stepped structure including one to two molecular layers. If there is a significant process damage at this stage, removal etching for a damaged layer is subsequently executed by using an acid having the pH equal to or below 1. Thereafter, Zn(OH)₂ is removed by etching using an acid having the pH set in a range of 2±0.5.

### (Example 2)

First, the main surface of the ZnO substrate is subjected to polishing by using colloidal silica to obtain a surface having a stepped structure including one to two molecular layers. If there is a significant process damage at this stage, etching is executed by using an acid having the pH equal to or below 1 and then etching is executed by using an acid containing fluorine and having the pH set in a range of 3.5±1 to dissolve silica on the ZnO substrate. Finally, etching is executed by using an acid having the pH set in a range of 2±0.5.

### (Example 3)

First, the main surface of the ZnO substrate is subjected to polishing by using colloidal silica to obtain a surface having a stepped structure including one to two molecular layers. If there is not a significant process damage at this stage, etching is executed by using an acid having the pH equal to or below 3. A time period for this etching varies depending on the pH but it is necessary to spend at least 15 second or longer.

In any of the above-described examples, reduction of the OH groups is confirmed as shown in Fig. 4.

## Claims

1. A zinc-oxide-based substrate,
wherein almost no hydroxide groups exist on a crystal growth-side surface of a MgₓZn₁₋ₓO substrate (0≤x<1).

2. The zinc-oxide-based substrate according to claim 1,
wherein the crystal growth-side surface is a main surface of the substrate having a +C plane, and
a line normal to the main surface of the substrate is inclined from a c-axis toward an m-axis, the c-axis and m-axis being crystal axes of the substrate.

3. The zinc-oxide-based substrate according to any one of claims 1 and 2,
wherein a defect density is equal to or below 1×10⁶ cm⁻² when a surface of a Mg_{y}Zn_{1-y}O substrate (0≤y<1) crystal-grown on the MgₓZn₁₋ₓO substrate (0≤x<1) is observed by use of optical means.

4. A method of processing a zinc-oxide-based substrate,
wherein a final treatment to be applied on the crystal growth-side surface of the MgₓZn₁₋ₓO substrate (0≤x<1) is acidic wet etching at pH 3 or lower.
